(19) Europäisches Patentamt
European Patent Office
Office européen des brevets

(11) **EP 3 332 481 B1**

(12) **EUROPÄISCHE PATENTSCHRIFT**

(45) Veröffentlichungstag und Bekanntmachung des Hinweises auf die Patenterteilung:
**12.10.2022 Patentblatt 2022/41**

(21) Anmeldenummer: **16754221.6**

(22) Anmeldetag: **02.08.2016**

(51) Internationale Patentklassifikation (IPC):
*H03K 17/691* (2006.01)   *H02M 7/5387* (2007.01)
*H02M 1/08* (2006.01)   *H02M 3/335* (2006.01)

(52) Gemeinsame Patentklassifikation (CPC):
**H02M 1/08; H02M 3/33573; H02M 7/5387**

(86) Internationale Anmeldenummer:
**PCT/EP2016/068420**

(87) Internationale Veröffentlichungsnummer:
**WO 2017/021404 (09.02.2017 Gazette 2017/06)**

(54) **ASYMMETRISCHE BIPOLARE SPANNUNGSVERSORGUNG**

ASYMMETRICAL BIPOLAR VOLTAGE SUPPLY

ALIMENTATION EN TENSION BIPOLAIRE ASYMÉTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.08.2015 DE 102015009797**

(43) Veröffentlichungstag der Anmeldung:
**13.06.2018 Patentblatt 2018/24**

(73) Patentinhaber: **iie GmbH & Co. KG**
**83564 Soyen (DE)**

(72) Erfinder: **KRESS, Ekkehard**
**83512 Wasserburg (DE)**

(74) Vertreter: **Oberhardt, Knut**
**Kanzlei Oberhardt**
**Unterratting 8**
**83123 AMERANG (DE)**

(56) Entgegenhaltungen:
| | |
|---|---|
| DE-A1-102005 001 322 | DE-B4-102005 001 322 |
| US-A- 3 938 025 | US-A1- 2012 092 895 |
| US-A1- 2015 137 871 | |

EP 3 332 481 B1

**Beschreibung**

Die Erfindung betrifft eine asymmetrische bipolare Spannungsversorgung nach dem Oberbegriff von Anspruch 1.

Moderne Leistungshalbleiter, die als Halbleiterschalter eingesetzt werden sollen, benötigen für die Gate-Ansteuerung eine asymmetrische bipolare Spannungsversorgung von beispielsweise +15 und -5 Volt. Dadurch sollen Fehlschaltungen verhindert werden. Solche Fehlschaltungen können auftreten, wenn die Gate-Ansteuerung zum Erreichen eines Schaltzustandes lediglich auf Null-Potential gesetzt wird, dieses Null-Potential aber durch eine Störung überlagert wird. In einem solchen Fall würde der Halbleiterschalter zu schwingen beginnen, was schnell zur Zerstörung führen würde. Wird dagegen eine Spannung von -5 Volt angelegt, kann auch eine Störung den ordnungsgemäßen Betrieb nicht behindern.

Um die Halbleiterschalter einer Vollbrücke (oder auch H-Brücke genannt) ansteuern zu können, werden mit der heute üblichen Technik vier Gate-Treiber benötigt, wobei jeder Gate-Treiber mit jeweils einer asymmetrischen bipolaren Spannungsquelle verbunden ist. Bei einer modernen Drehstrom Stromversorgung mit Power Factor Correction (PFC) und nachgeschaltetem Vollbrücken-Spannungswandler sind 6 Halbleiterschalter für die PFC und 4 Halbleiterschalter für den nachgeschalteten Vollbrücken-Spannungswandler notwendig. Es werden also 10 Gate-Treiber mit den zugehörigen asymmetrischen bipolaren Spannungsquellen benötigt. Für einen rückspeisefähigen Frequenzumrichter werden sogar mindestens 12 Gatetreiber mit den o.g. asymmetrischen bipolaren Spannungsquellen benötigt.

In der US 2015/0137871 A1 wird für den Aufbau einer solchen Spannungsquelle ein Transformator verwendet, der eine entsprechende Anzahl von Sekundärwicklungen aufweist. Für die positive und die negative Spannung wird jeweils eine eigene Wicklung benötigt, wobei die positive und die negative Wicklung einen gemeinsamen Massepunkt besitzen können. Die Ausgangsspannungen werden über das Verhältnis der Windungen von Primärwicklung und Sekundärwicklung eingestellt.

Das bedeutet, dass für jeden Gate-Treiber zwei Sekundärwicklungen vorzusehen sind. Bei der oben erwähnte Vollbrückenschaltung werden folglich bereits 8 Sekundärwicklungen und bei der oben erwähnte Drehstromversorgung sogar 20 Sekundärwicklungen benötigt.

Diese große Anzahl von Sekundärwicklungen führt zu einer Baugröße, die hohe parasitäre Kapazitäten mit sich bringt. Diese parasitären Kapazitäten können zu Störungen führen, die durch Ableitströme hervorgerufen werden und im schlimmsten Fall zu einer Zerstörung der Spannungsversorgung oder der Gate-Treiber führen.

Die US 2012/0092895 A1 zeigt eine Schaltung zur potentialgetrennten Energieübertragung von einer Primär- zu einer Sekundärseite mit zwei sekundärseitigen Ausgleichsspannungen. Ein Transformator weist hierzu zwei Primärspulen mit einer gemeinsamen Mittelanzapfung und eine Sekundärspule auf. Die Windungszahlen der beiden Primärspulen verhalten sich wie die sekundärseitigen Ausgleichsspannungen. Die Mittelanzapfung liegt an einer Gleichspannungsquelle an. Die beiden Primärspulen können jeweils über einen Transistor auf das Grundpotential der Gleichspannungsquelle geschaltet werden.

In der US 3 938 025 A ist ein Gleichspannung-zu-Gleichspannung-Wandler gezeigt, der zwei individuell steuerbare, stabilisierte Spannungen im Bereich von mehreren Kilovolt erzeugt. Hier werden - im Gegensatz zu der US 2012/0092895 A1 - zwei Primärspulen verwendet, die über zwei unterschiedliche Gleichspannungsquellen versorgt werden.

Der Erfindung liegt die Aufgabe zugrunde, eine asymmetrische bipolare Spannungsversorgung so auszubilden, dass die oben beschriebenen Nachteile vermieden oder zumindest minimiert werden können.

Gelöst wird die Aufgabe gemäß der Erfindung durch eine asymmetrische bipolare Spannungsversorgung mit den Merkmalen von Anspruch 1. Dadurch, dass bereits die primärseitige Spannungsversorgung mit zwei Gleichspannungsquellen verbunden und so aufgebaut ist, dass in dem Transformator zwei entgegengesetzt polarisierte Windungsspannungen $U_{W1}$ und $U_{W2}$ mit unterschiedlichen Amplituden erzeugbar sind, lässt sich die Anzahl der notwendigen Sekundärwicklungen auf die Hälfte reduzieren. Bei der erfindungsgemäßen Spannungsversorgung wird bereits auf der Primärseite eine asymmetrische bipolare Wechselspannung erzeugt, die jeweils in die Sekundärwicklungen induziert wird. An den Sekundärwicklungen kann folglich eine Wechselspannung mit unterschiedlichen Amplituden im positiven und im negativen Bereich abgegriffen werden. Als Windungsspannung ist die pro Windung induzierte Spannung zu verstehen. Weitere Einzelheiten und Vorteile der Erfindung ergeben sich aus den Unteransprüchen.

Zur Erzeugung einer asymmetrischen, bipolaren Wechselspannung an der primärseitigen

Wicklung weist die primärseitige Spannungsversorgung eine Vollbrückenschaltung mit vier primären Halbleiterschaltern auf, wobei jeder Schenkel der Vollbrückenschaltung mit einer anderen Gleichspannungsquelle verbunden ist.

Um auf eine Regelung der sekundärseitigen Spannung verzichten zu können, ist wenigstens eine mit der primärseitigen Spannungsversorgung verbundene Gleichspannungsquelle geregelt. Solche geregelten Gleichspannungsquellen sind üblich und deshalb sehr preiswert auf dem Markt erhältlich.

Bei der Erzeugung der Wechselspannung auf der Primärseite des Transformators ist darauf zu achten, dass zu keinem Zeitpunkt die magnetische Sättigung erreicht wird. Zu diesem Zweck muss der Verlauf der Wechselspannung bestimmten Bedingungen genügen. Die primären Halbleiterschalter werden deshalb so geschaltet, dass an der wenigstens einen Primärwicklung während einer Zeitspanne $t_1$ die Windungsspannung $U_{W1}$ und während einer Zeitspanne $t_2$ die invertierte Windungsspannung $U_{W2}$ anliegt, wobei das Integral unter der Windungsspannung $U_{W1}$ über die Zeitspanne $t_1$ dem Integral unter der Windungsspannung $U_{W2}$ über die Zeitspanne $t_2$ entspricht. Da bei der erzeugten Wechselspannung die Amplituden unterschiedliche Vorzeichen besitzen, ist bei dem Integral der jeweilige Absolutbetrag gemeint.

Vorteilhaft sind sekundärseitig ebenfalls mehrere sekundäre Halbleiterschalter vorgesehen. Jedem dieser sekundären Halbleiterschalter ist genau eine Sekundärwicklung zugeordnet. Da bereits auf der Primärseite eine asymmetrische bipolare Wechselspannung erzeugt wird, sind auf der Sekundärseite keine zwei Wicklungen für jeden sekundären Halbleiterschalter notwendig. Gegenüber dem Stand der Technik lässt sich folglich die Anzahl der Sekundärwicklungen halbieren.

Jede Sekundärwicklung liefert eine Spannung mit positivem Vorzeichen und eine zweite Spannung mit unterschiedlicher Amplitude und mit negativem Vorzeichen. Beide Spannungen müssen einem Treiber zur Verfügung gestellt werden, so dass an das Gate der sekundären Halbleiterschalter die entsprechende Schaltspannung angelegt werden kann.

Es wird deshalb jeder sekundäre Halbleiterschalter durch einen ihm zugeordneten Treiber angesteuert.

Um den Treibern die beiden notwendigen Schaltspannungen zur Verfügung stellen zu können, sind die beiden Spannungs-Eingänge eines jeden Treibers mit dem Ausgang einer dem Treiber zugeordneten Gleichrichterschaltung mit Dioden und Kondensatoren verbunden. Auf diese Weise liegt an dem einen Spannungseingang des Treibers immer eine positive Spannung mit bestimmter Amplitude an, während an dem anderen Spannungseingang des Treibers immer eine negative Spannung mit unterschiedlicher Amplitude anliegt.

Jede Sekundärwicklung versorgt Z eine Gleichrichterschaltung mit

Spannung. Das bedeutet, dass für jeden sekundären Halbleiterschalter eine eigene Spannungsversorgung für die Ansteuerung des Gates vorgesehen ist. Diese Spannungsversorgung wird über eine Sekundärwicklung gespeist und weist weiterhin eine Gleichrichterschaltung und einen Treiber auf. Die Spannungsversorgungen sind für alle sekundären Halbleiterschalter identisch.

Um eine auf eine bestimmte Last abgestimmte Wechselspannung erzeugen zu können, wird jeder Treiber durch eine Steuerung angesteuert. Über die Steuerung wird folglich festgelegt, ob die an dem Treiber anliegende positive Spannung mit bestimmter Amplitude, oder die an dem Treiber anliegende negative Spannung mit unterschiedlicher Amplitude auf das Gate des sekundären Halbleiterschalters durchgeschaltet wird.

Vorteilhaft bilden die sekundären Halbleiterschalter eine sekundärseitige Vollbrückenschaltung, die über eine weitere Gleichspannungsquelle mit Gleichspannung versorgt wird. Hier sind diagonale sekundäre Halbleiterschalter gleich geschaltet, so dass auf eine angeschlossene Last eine rechteckförmige Wechselspannung gelegt werden kann. Für diese Anwendung sind vier Sekundärwicklungen und vier sekundäre Halbleiterschalter notwendig.

Für eine Drehstromversorgung mit PFC werden allein für die PFC pro Phase zwei sekundäre Halbleiterschalter und zwei Sekundärwicklungen benötigt. Zu diesen sechs Sekundärwicklungen und sechs sekundären Halbleiterschaltern kommen dann noch vier weitere Sekundärwicklungen und sekundäre Halbleiterschalter für die nachgeschaltete Vollbrücke. Es werden folglich für diese Anwendung insgesamt zehn Sekundärwicklungen und zehn sekundäre Halbleiterschalter benötigt.

Der Transformator kann als üblicher Wickeltransformator ausgebildet sein. Insbesondere bei Anwendungen, bei denen eine große Anzahl von Sekundärwicklungen benötigt wird, ergeben sich aber durch die Verwendung eines Planartransformators enorme Vorteile. Bei diesem Planartransformator wird für jede Wicklung (wenigstens eine Primärwicklung und Sekundärwicklungen) jeweils ein Layer einer Multilayer-Platine vorgesehen. Besonders vorteilhaft ist der Transformator deshalb als Planartransformator aufgebaut, wobei ein oberer und ein unterer Layer mit je einer Primärwicklung vorgesehen sind, zwischen denen die Layer mit den Sekundwicklungen angeordnet sind.

Weitere Einzelheiten und Vorteile der Erfindung ergeben sich aus der Beschreibung eines Ausführungsbeispiels, das anhand der Zeichnung eingehend erläutert wird.

Es zeigt:

Fig. 1      einen schematisierten Schaltplan eines Ausführungsbeispiels einer asymmetrischen bipolaren Spannungsversorgung nach der Erfindung,

Fig. 2      eine schematische Ansicht eines Planartransformators für eine erfindungsgemäße Spannungsversorgung,

Fig. 3      die Ausgangsspannung der primärseitigen Vollbrückenschaltung,

Fig. 4      eine erste alternative primärseitige Spannungsversorgung und

Fig. 5      eine zweite alternative primärseitige Spannungsversorgung.

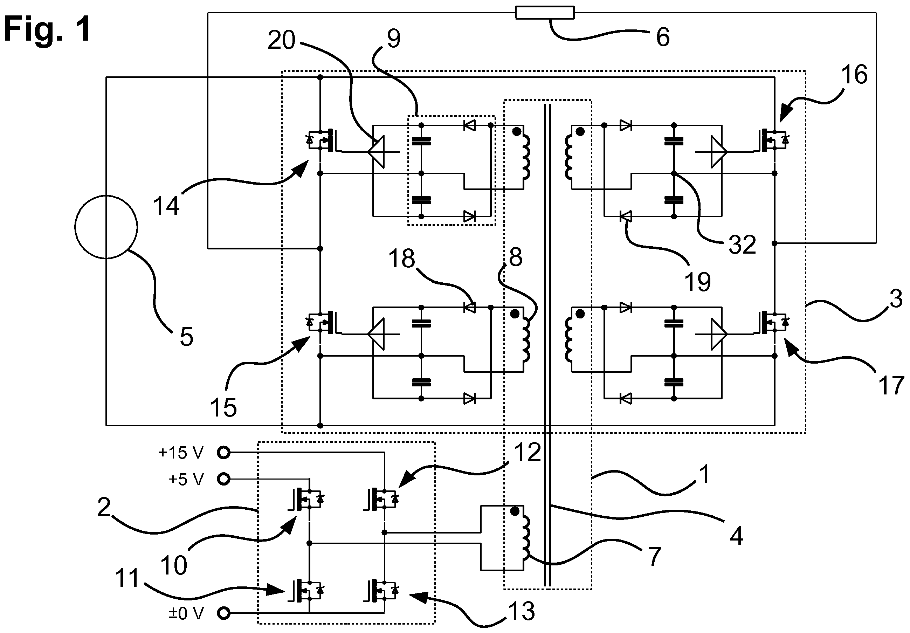

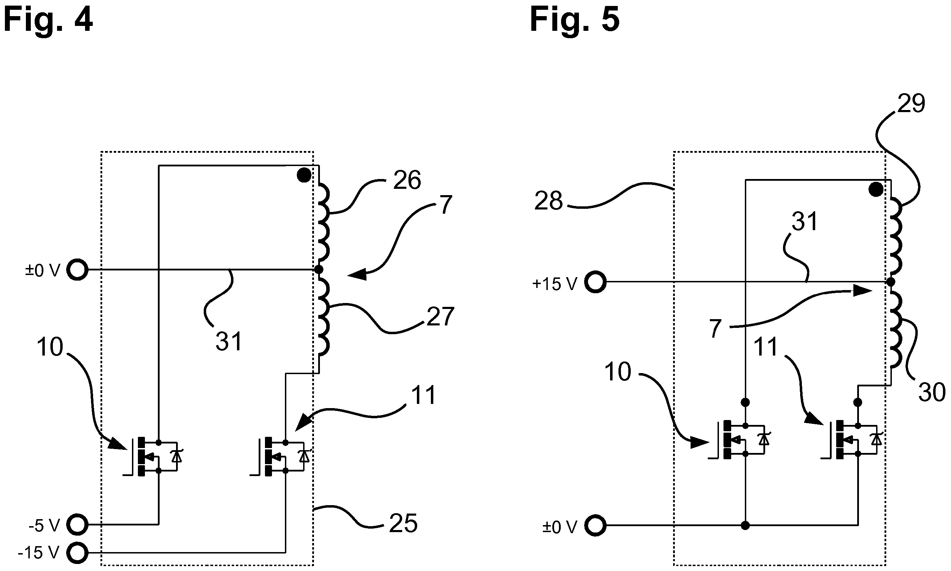

Fig. 4 und 5 zeigen Ausführungsbeispiele, die nicht durch die Erfindung abgedeckt sind. Für die Gate-Ansteuerung von modernen schnellen Halbleiterschaltern, wie beispielsweise SiC- oder GaN-FETs, wird oft eine bipolare Spannungsversorgung benötigt, die sowohl eine Spannung in Höhe von +15 V, als auch eine Spannung in Höhe von -5 V liefert. Die Erfindung soll deshalb an einem Ausführungsbeispiel einer entsprechenden asymmetrischen bipolaren Spannungsversorgung erläutert werden. Fig. 1 zeigt einen schematisierten Schaltplan einer solchen Spannungsversorgung, in dem auf die Darstellung von Details verzichtet wurde, die für die Erfindung nicht wesentlich sind.

Die Schaltung weist einen Transformator 1 auf, der eine Primärwicklung 7 und 4 Sekundärwicklungen 8 aufweist. Auf der Primärseite des Transformators 1 ist eine Vollbrückenschaltung 2 vorgesehen, die durch die vier primären Halbleiterschalter 10 bis 13 gebildet wird. Die beiden Schenkel der Vollbrückenschaltung 2 werden mit unterschiedlichen geregelten Gleichspannungen versorgt. So ist der links dargestellte Schenkel der primärseitigen Vollbrückenschaltung 2 mit einer geregelten Gleichspannungsquelle verbunden, die eine Gleichspannung in Höhe von +5 V liefert, während die geregelte Gleichspannungsquelle für den rechts dargestellten Schenkel der primärseitigen Vollbrückenschaltung 2 eine Gleichspannung in Höhe von +15 V liefert. Die Ansteuerung der primären Halbleiterschalter 10 bis 13 ist nicht dargestellt, da sie für die Erfindung nicht wesentlich ist.

Sekundärseitig ist ebenfalls eine Vollbrückenschaltung 3 vorgesehen, die durch die vier sekundären Halbleiterschalter 14 bis 17 gebildet wird. Die sekundären Halbleiterschalter 14 bis 17 werden durch jeweils einen Treiber 20 angesteuert, der über die Sekundärwicklung 8 und eine Gleichrichterschaltung 9 mit einer asymmetrischen bipolaren Gleichspannung in Höhe von +15 V und von -5 V versorgt wird. Die Ansteuerung der Treiber 20 ist nicht eingezeichnet, da sie für das Verständnis der Erfindung nicht wesentlich ist.

Die sekundärseitige Vollbrückenschaltung 3 wird durch die Gleichspannungsquelle 5 mit einer Gleichspannung versorgt. Über die sekundärseitige Vollbrückenschaltung 3 kann die Gleichspannung der Gleichspannungsquelle 5 in eine Wechselspannung zur Spannungsversorgung der Last 6 gewandelt werden.

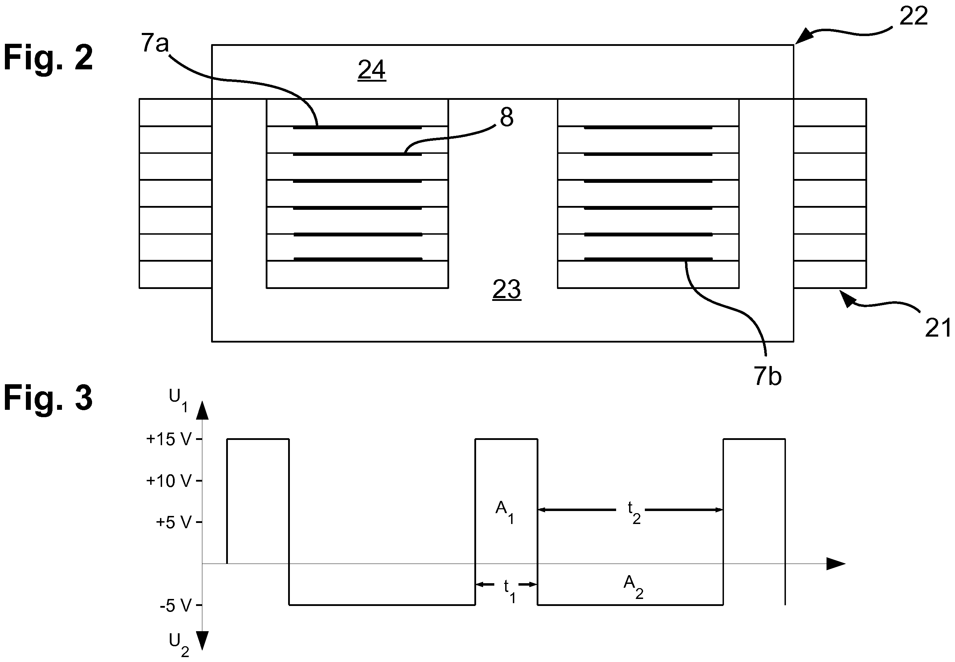

Fig. 2 zeigt schematisch einen Planartransformator, der einen E-I-Kern 22 und eine Multilayer-Platine 21 aufweist. Der E-Teil 23 des Kerns 22 ist durch Ausnehmungen der Multilayer-Platine 21 gesteckt. Der I-Teil 24 wurde danach mit den Schenkeln des E-teils 23 verbunden.

In jedem Layer ist eine Wicklung realisiert, die im Idealfall aus einer einzigen Windung besteht. In dem hier gezeigten Ausführungsbeispiel sind - anders als in dem Ausführungsbeispiel nach Fig. 1 - zwei Primärwicklungen 7a und 7b vorgesehen. Die vier Sekundärwicklungen 8 sind zwischen den beiden Primärwicklungen 7a und 7b angeordnet. Auf diese Weise lässt sich durch die Primärwicklungen 7a und 7b ein sehr homogenes Magnetfeld erzeugen, dem die Sekundärwicklungen 8 angeordnet sind. In dem hier gezeigten Beispiel enthält die Multilayer-Platine 21 sechs Layer und ist oben und unten mit einer Abdeckung gegen den Kern 22 versehen.

Die beiden Primärwicklungen 7a und 7b können parallel geschaltet sein und mit der selben primärseitigen Vollbrückenschaltung mit Spannung versorgt werden. Es besteht aber ebenso die Möglichkeit, die beiden Primärwicklungen 7a und 7b in Reihe zu verschalten. Für diesen Fall müssen jedoch primärseitig Gleichspannungsquellen vorgesehen werden, die höhere Spannungen, also hier für den linken Schenkel 10 V und für den rechten Schenkel 30 V liefert.

Der dargestellte Planartransformator ist für die Schaltung der sekundärseitigen Vollbrückenschaltung mit vier Sekundärwicklungen 8 ausgestattet. Es werden nicht mehr acht Sekundärwicklungen wie bei einer Schaltung nach dem Stand der Technik benötigt. Bei einer modernen Drehstrom Stromversorgung mit PFC und nachgeschaltetem Vollbrücken-Spannungswandler sind dagegen (hier nicht gezeigt) zur Ansteuerung der zehn notwendigen Halbleiterschalter auch zehn Sekundärwicklungen vorzusehen (anstatt 20 Sekundärwicklungen nach dem Stand der Technik). Ein Planartrafo für eine solche Anwendung würde folglich zwölf Layer aufweisen.

Durch diese Halbierung der Anzahl von Sekundärwicklungen gegenüber dem Stand der Technik lässt sich auch die Baugröße der Spannungsversorgung enorm reduzieren. Da aber mit der Verringerung der Baugröße auch eine Verringerung der parasitären Kapazitäten einhergeht, kann eine starke Reduzierung von Störungen und damit von Fehlschaltungen gewährleistet werden. Weiterhin verringern sich mit der Baugröße und der Anzahl der notwendigen Layer auch die Herstellkosten.

Die primärseitige Vollbrückenschaltung kann mit einer Frequenz von mehreren hundert Kilohertz, also beispielsweise mit 600 kHz betrieben werden. Dabei werden die primären Halbleiterschalter 10 bis 13 immer paarweise diagonal geschaltet. Also schalten beispielsweise die primären Halbleiterschalter 10 und 13 auf Durchgang, während die primären Halbleiterschalter 11 und 12 gleichzeitig auf Sperrung schalten. In diesem ersten Zustand der primärseitigen Vollbrückenschaltung 2 liegt an dem unteren Ende der Primärwicklung 7 eine Spannung in Höhe von +5 V gegen das obere Ende der Primärwicklung 7 an. Wenn die Primärwicklung 7 aus einer einzigen Windung besteht, beträgt die Windungsspannung $U_{W1}$ in diesem Schaltzustand -5 V.

Nach dem Schalten der primärseitigen Vollbrückenschaltung 2 in einen zweiten Zustand sind die primären Halbleiterschalter 11 und 12 auf Durchgang geschaltet, während die primären Halbleiterschalter 10 und 13 auf Sperrung geschaltet sind. In diesem zweiten Zustand liegt am oberen Ende der Primärwicklung 7 eine Spannung von +15 V gegen das untere Ende der Primärwicklung 7 an. Bei einer Primärwicklung 7 mit nur einer Windung beträgt die Windungsspannung $U_{W2}$ in diesem Schaltzustand +15 V.

Im Folgenden wird davon ausgegangen, dass das Verhältnis der Sekundärwicklungen 8 zu der Primärwicklung 7 (Fig. 1) 1:1:1:1:1 beträgt. In den beiden mög-

lichen Schaltzuständen der primärseitigen Vollbrücken-schaltung 2 fließt der Strom in jeweils entgegengesetzter Richtung. Das bewirkt, dass mit den Sekundärwicklungen 8 eine Spannung erzeugt wird, die, mit dem Wechsel der Schaltzustände der primärseitigen Vollbrückenschaltung 2, zwischen +15 V und -5 V wechselt. Es wird folglich eine Wechselspannung erzeugt, die eine asymmetrische Amplitude aufweist und zwischen +15 V und -5 V wechselt.

Der Spannungsverlauf an der Primärwicklung 7 und folglich auch an den Sekundärwicklungen 8 ist in Fig. 3 dargestellt. Es handelt sich dabei um eine Rechteckspannung mit einer ersten Amplitude von +15 V und einer zweiten Amplitude von -5 V. Um zu verhindern, dass der Planartransformator 1 die magnetische Sättigung erreicht, muss die Bedingung

$$U_1 \times t_1 = U_2 \times t_2 \quad (1)$$

erfüllt sein. Demnach müssen die Flächen $A_1$ und $A_2$, die dem jeweiligen Integral der Spannung mit positiver Amplitude beziehungsweise mit negativer Amplitude entsprechen, eine identische Größe aufweisen. In dem hier dargestellten Beispiel beträgt die Amplitude der positiven Spannung $U_1$ das Dreifache wie die Amplitude der negativen Spannung $U_2$. Demzufolge muss die Zeitspanne $t_2$ für die Spannung mit negativer Amplitude ebenfalls das Dreifache der Zeitspanne $t_1$ für die Spannung mit positiver Amplitude betragen.

Es gilt:

$U_1 = 3 U_2$ und folglich eingesetzt in (1)
$3 U_2 \times t_1 = U_2 \times t_2$ also
$t_2 = 3 t_1$

Diese asymmetrische Wechselspannung liegt an jeder der vier Gleichrichterschaltungen 9 an. Die Gleichrichterdiode 18 ist durchgängig für Ströme, die fließen, wenn am oberen Ende der Sekundärwicklung die positive Spannung (hier von +15 V) gegen das untere Ende der Sekundärwicklung anliegt und sperrt für Ströme die fließen, wenn an dem oberen Ende der Sekundärwicklung die negative Spannung (hier von -5 V) gegen das untere Ende der Sekundärwicklung anliegt. Die Gleichrichterdiode 19 verhält sich genau umgekehrt. Sie sperrt Ströme, die fließen, wenn am oberen Ende der Sekundärwicklung die positive Spannung (hier von +15 V) gegen das untere Ende der Sekundärwicklung anliegt und ist durchgängig für Ströme, die fließen, wenn am oberen Ende der Sekundärwicklung die negative Spannung (hier von -5 V) gegen das untere Ende der Sekundärwicklung anliegt.

In der Zeitspanne $t_1$ liegt folglich am oberen Eingang des Treibers 20 - also dem Eingang für die positive Spannungsversorgung - eine Spannung von +15 V gegen den Spannungsbezugspunkt 32 an. Gleichzeitig wird der obere Kondensator aufgeladen. Während der Zeit-spanne $t_2$ liegt dagegen an dem unteren Eingang des Treibers 20 - also dem Eingang für die negative Spannungsversorgung - eine Spannung von -5 V gegen den Spannungsbezugspunkt 32 an, während gleichzeitig der untere Kondensator geladen wird. Bei entsprechender Abstimmung der beiden Kondensatoren wird folglich über die entsprechende Diode immer einer der Kondensatoren geladen, während gleichzeitig die induzierte Spannung an dem entsprechenden Eingang des Treibers 20 anliegt. Während dieser Zeitspanne liegt an dem jeweils anderen Eingang des Treibers 20 die Spannung aus dem entsprechenden Kondensator an, der gerade nicht geladen wird.

Jeder der Treiber 20 wird folglich ständig mit einer asymmetrischen bipolaren Gleichspannung von +15 V und -5 V versorgt. Dabei liegt die Spannung von +15 V immer an dem oberen Eingang und die Spannung mit -5 V immer an dem unteren Eingang an.

Die Last 6 soll mit einer Wechselspannung betrieben werden, die über die sekundärseitige Vollbrückenschaltung 3 erzeugt werden soll. Die sekundärseitige Vollbrückenschaltung 3 wird von einer Gleichspannungsquelle 5 versorgt. Auch werden die sekundären Halbleiterschalter 14 bis 17 paarweise diagonal geschaltet, so dass sich immer die Halbleiterschalter 14 und 17, beziehungsweise 15 und 16 im gleichen Schaltzustand befinden. Die Halbleiterschalter 14 bis 17 werden dabei über den jeweiligen Treiber 20 angesteuert wobei an die Gates der Halbleiterschalter entweder eine Spannung von +15 V oder eine Spannung von - 5 V angelegt wird. Die Treiber wiederum werden von einer hier nicht gezeigten Steuerung in der benötigten Weise und der benötigten Frequenz angesteuert. Selbstverständlich können auch noch Schaltungen vorgesehen sein, um dem Ausgangssignal der sekundärseitigen Vollbrückenschaltung 3 eine beliebige Form zu geben oder um eine Pulsweitenmodulation durchzuführen, die hier aber aus Gründen der Übersichtlichkeit ebenfalls nicht gezeigt sind.

Mit der erfindungsgemäßen Spannungsversorgung lassen sich durch die stark verminderte Anzahl von Sekundärwicklungen 8 sehr kleine Baugrößen erreichen. Parasitäre Kapazitäten können auf diese Weise sehr gering gehalten werden. Auch die Herstellkosten werden so gesenkt.

Optimal ist die Aufgabe mit Planartransformatoren zu lösen, die in Multilayer- Leiterplatten-Technologie realisiert werden. Bei dieser Technologie ist für jede Wicklung ein eigener Layer zu verwenden.

Bei der Realisierung einer Drehstrom Stromversorgung mit PFC (nicht in der Zeichnung gezeigt) wäre nach herkömmlicher Technik bei der Verwendung von zwei Primärwicklungen eine Leiterplatte mit 22 Layern vorzusehen. Mit Hilfe der Erfindung kann diese Spannungsversorgung mit einer Leiterplatte mit lediglich 12 Layern realisiert werden. Dadurch ergibt sich ein immenser Platz- und Kostenvorteil.

Für die unterschiedliche positive und negative Spannung wird nur noch eine Sekundärwicklung benötigt. Der Transformator wird so angesteuert, dass die beiden Halbwellen einer Periode unterschiedliche Amplituden haben. So ist es möglich mit einer Sekundärwicklung mittels Trennung durch zwei Dioden sowohl +15 V als auch -5 V zu erzeugen.

Gemäß zwei nicht beanspruchten Ausführungsbeispiele kann an Stelle einer primärseitigen Vollbrückenschaltung auch eine Gegentaktschaltung mit nur zwei Halbleiterschaltern und einer Primärwicklung mit Anzapfung Verwendung finden. Solche alternativen Schaltungen sind in den Figuren 4 und 5 dargestellt. Gleiche Bauteile wie in Fig. 1 sind mit den gleichen Bezugszeichen versehen. Fig. 4 zeigt eine primärseitige Spannungsversorgung mit einer doppelt gespeisten Gegentaktschaltung 25. Dabei ist die Primärwicklung 7 aus symmetrischen Primärwicklungsteilen 26 und 27 auf beiden Seiten einer als Mittenanzapfung ausgelegten Anzapfung 31 aufgebaut. Die beiden symmetrischen Primärwicklungsteile 26 und 27 besitzen die gleiche Anzahl von Windungen. Hier sind - wie auch bei der Vollbrückenschaltung 2 nach Fig. 1 - zwei unterschiedliche Gleichspannungsquellen erforderlich.

Genauso wie in Fig. 1 sind aber auch zwei Schaltzustände möglich: In einem ersten Schaltzustand ist der erste Halbleiterschalter 10 auf Durchgang und der zweite Halbleiterschalter 11 auf Sperrung geschaltet. In diesem Schaltzustand liegt an dem oberen Ende des symmetrischen ersten Primärwicklungsteils 26 eine Spannung von -5 V an, während das untere Ende des symmetrischen ersten Primärwicklungsteils 26 über die Mittelanzapfung 31 auf Null-Potential liegt. Wenn das erste Primärwicklungsteil 26 nur eine Windung aufweist, beträgt die Windungsspannung $U_{W1}$ in diesem Schaltzustand wiederum -5 V. In einem zweiten Schaltzustand ist der erste Halbleiterschalter 10 auf Sperrung und der zweite Halbleiterschalter 11 auf Durchgang geschaltet. In diesem zweiten Schaltungszustand liegt an dem unteren Ende des symmetrischen zweiten Primärwicklungsteils 27 eine Spannung von -15 V an, während das obere Ende des symmetrischen zweiten Primärwicklungsteils wiederum über die Mittelanzapfung 31 auf Null-Potential liegt. Bei einem zweiten Primärwicklungsteil 27 mit nur einer Windung beträgt die Windungsspannung $U_{W2}$ in diesem Schaltzustand wiederum +15 V.

Die asymetrische bipolare Wechselspannung an der Primärwicklung 26 und 27 wird hier folglich durch eine Gegentaktschaltung erreicht, die die Primärwicklung 7 alternierend mit einer Gleichspannungsquelle und invertiert mit einer anderen Gleichspannungsquelle verbindet. Diese asymetrische bipolare Wechselspannung wird direkt in die Sekundärspulen induziert.

Fig. 5 dagegen zeigt eine primärseitige Spannungsversorgung mit einer einfachgespeisten Gegentaktschaltung 28. Dabei ist die Primärwicklung 7 aus asymmetrischen Primärwicklungsteilen 29 und 30 auf beiden Seiten einer Anzapfung 31 aufgebaut. Die beiden Primärwicklungsteile 29 und 30 besitzen eine unterschiedliche Anzahl von Windungen. In dem gezeigten Beispiel weist der asymmetrische erste Primärwicklungsteil 29 drei Windungen auf, während der asymmetrische zweite Primärwicklungsteil 30 nur eine Windung aufweist.

In einem ersten Schaltzustand ist der erste Halbleiterschalter 10 auf Durchgang und der zweite Halbleiterschalter 11 auf Sperrung geschaltet. In diesem Schaltzustand liegt an dem unteren Ende des asymmetrischen ersten Primärwicklungsteils 29 über die Anzapfung 31 eine Spannung von +15 V an, während das obere Ende des asymmetrischen ersten Primärwicklungsteils 29 auf Null-Potential liegt. Durch die drei Windungen des Primärwicklungsteils 29 und durch die angelegten Polarität der Spannung ergibt sich eine negative Windungsspannung $U_{W1}$ von -5 V. Da die Sekundärwicklungen nur eine Windung aufweisen, wird in diesem Schaltzustand eine Spannung von -5 V in die Sekundärwicklungen induziert.

In einem zweiten Schaltzustand ist der erste Halbleiterschalter 10 auf Sperrung und der zweite Halbleiterschalter 11 auf Durchgang geschaltet. In diesem zweiten Schaltungszustand liegt die Spannung von +15 V über die Anzapfung 31 an dem oberen Ende des asymmetrischen zweiten Primärwicklungsteil 30, während das untere Ende des asymmetrischen zweiten Primärwicklungsteils auf Null-Potential liegt. Da das zweite Primärwicklungsteil 30 nur eine Windung besitzt, wird mit der angelegten Polarität in diesem Schaltzustand eine positive Windungsspannung $U_{W2}$ von +15 V erzeugt. Hier wird über die asymmetrische Primärwicklung folglich eine bipolare asymmetrische Magnetisierung des Transformators erreicht. Da die Sekundärwicklungen wiederum nur eine Windung aufweisen, wird in diesem Schaltzustand eine Spannung von +15 V in die Sekundärwicklungen induziert.

Die Asymetrie der in den Sekundärwicklungen induzierten Wechselspannung kommt durch das Übersetzungsverhältnis zwischen dem jeweiligen Primärwicklungsteil 29 oder 30 und den Sekundärwicklungen zustande. So beträgt das Übersetzungsverhältnis im ersten Schaltzustand 3:1, so dass in die Sekundärwicklungen nur eine Spannung von -5 V induziert wird. Im zweiten Schaltzustand dagegen beträgt das Übersetzungsverhältnis zwischen Primärwicklung und Sekundärwicklung 1:1, so dass in den Sekundärwicklungen die vollen +15 V aus der Primärwicklung induziert werden.

Auch bei den in Fig. 4 und Fig. 5 gezeigten Ausführungsbeispielen mit Gegentaktschaltung und Primärwicklung 26 und 27 oder 29 und 30, jeweils mit Anzapfung 31 muss die Einschaltdauer an die jeweilige Halbwellenspannung angepasst werden. Die Halbwelle, die in den Sekundärwicklungen eine Amplitude von 5 V erzeugt, erstreckt sich deshalb über einen Zeitraum, der dreimal so lang ist wie der Zeitraum der Halbwelle, die in den Sekundärwicklungen eine Amplitude von 15 V erzeugt.

Es soll noch erwähnt werden, dass gemäß einem weiteren Ausführungsbeispiel, welches nicht in den Schutzumfang der Ansprüche fällt, selbstverständlich auch die Möglichkeit besteht, zwei voneinander unabhängige Primärwicklungen zu verwenden, von denen jede mit einer eigenen Spannungsversorgung verbunden ist. In diesem Fall werden die Primärspulen abwechselnd mit Spannung versorgt. Während an die erste Primärwicklung während einer Zeitspanne $t_1$ ein Rechteck-Impuls mit +15 V angelegt wird, wird die zweite Primärwicklung mit keiner Spannung versorgt. Während einer darauf folgenden Zeitspanne $t_2$, die wiederum dreimal so lange wie $t_1$ andauert, wird dagegen die erste Primärwicklung spannungslos geschaltet und an die zweite Primärwicklung eine Spannung von -5 V angelegt.

Bezugszeichenliste:

1    Planartransformator
2    primärseitige Vollbrückenschaltung
3    sekundärseitige Vollbrückenschaltung
4    Kern
5    Gleichspannungsquelle
6    Last
7    Primärwicklung
8    Sekundärwicklung
9    Gleichrichterschaltung
10   erster primärer Halbleiterschalter
11   zweiter primärer Halbleiterschalter
12   dritter primärer Halbleiterschalter
13   vierter primärer Halbleiterschalter
14   erster sekundärer Halbleiterschalter
15   zweiter sekundärer Halbleiterschalter
16   dritter sekundärer Halbleiterschalter
17   vierter sekundärer Halbleiterschalter
18   Gleichrichterdiode für +15 V
19   Gleichrichterdiode für -5 V
20   Treiber
21   Multilayer-Platine
22   E-I-Kern
23   E-Teil
24   I-Teil
25   primärseitige doppelt gespeiste Gegentaktschaltung
26   symmetrischer erster Primärwicklungsteil
27   symmetrischer zweiter Primärwicklungsteil
28   primärseitige einfach gespeiste Gegentaktschaltung
29   asymmetrischer erster Primärwicklungsteil
30   asymmetrischer zweiter Primärwicklungsteil
31   Anzapfung
32   Spannungsbezugspunkt

**Patentansprüche**

1.  Asymmetrische bipolare Spannungsversorgung mit einem Transformator (1), zwei Gleichspannungsquellen mit unterschiedlichen Spannungen (U1, U2), und einer primärseitigen Spannungsversorgung (2), wobei der Transformator (1) eine Primärwicklung (7) und mehrere Sekundärwicklungen (8) aufweist **dadurch gekennzeichnet, dass** die primärseitige Spannungsversorgung eine Vollbrückenschaltung (2) mit vier primären Halbleiterschaltern (10-13) aufweist, wobei jeder Schenkel der Vollbrückenschaltung (2) mit einer anderen der zwei Gleichspannungsquellen und mit einem anderen Ende der Primärwicklung (7) verbunden ist, womit in dem Transformator (1) in einer Periode zwei entgegengesetzt polarisierte Windungsspannungshalbwellen Uw1 und Uw2 mit unterschiedlichen Amplituden erzeugbar sind, so dass an jeder Sekundärwicklung entgegengesetzt polarisierte Spannungen mit unterschiedlicher Amplitude abgreifbar sind, und dass jede Sekundärwicklung (8) mit einer entsprechenden Gleichrichterschaltung (9) verbunden ist, wobei jede Gleichrichterschaltung (9) dazu ausgelegt ist um zwei asymmetrischen bipolaren Spannungen zu erzeugen.

2.  Asymmetrische bipolare Spannungsversorgung nach Anspruch 1, **dadurch gekennzeichnet, dass** wenigstens eine mit der primärseitigen Spannungsversorgung (2) zu verbindende Gleichspannungsquelle geregelt ist.

3.  Asymmetrische bipolare Spannungsversorgung nach einem der Ansprüche 1 bis 2, **dadurch gekennzeichnet, dass** die primären Halbleiterschalter (10-13) dazu ausgelegt sind um so geschaltet zu werden, dass an der wenigstens einen Primärwicklung (7) während einer Zeitspanne $t_1$ die Windungsspannung $U_{W1}$ und während einer Zeitspanne $t_2$ die invertierte Windungsspannung $U_{W2}$ anliegt, wobei das Integral unter der Windungsspannung $U_{W1}$ über die Zeitspanne $t_1$ dem Integral unter der Windungsspannung Uw2 über die Zeitspanne $t_2$ entspricht.

4.  System umfassend eine sekundärseitige Vollbrückenschaltung (3) und die asymmetrische bipolare Spannungsversorgung nach einem der Ansprüche 1 bis 3, **dadurch gekennzeichnet, dass** sekundärseitig mehrere sekundäre Halbleiterschalter (14-17) vorgesehen sind, wobei jedem sekundären Halbleiterschalter (14-17) genau eine Sekundärwicklung (8) zugeordnet ist.

5.  System nach Anspruch 4, **dadurch gekennzeichnet, dass** jedem sekundären Halbleiterschalter (14-17) ein Treiber (20) zur Ansteuerung desjenigen Halbleiterschalters (14-17) zugeordnet ist.

6.  System nach Anspruch 5, **dadurch gekennzeichnet, dass** die beiden Spannungs-Eingänge eines jeden Treibers (20) mit dem Ausgang einer dem Treiber (20) zugeordneten Gleichrichterschaltung (9) mit Dioden und Kondensatoren verbunden sind.

7. System nach einem der Ansprüche 5 bis 6, **dadurch gekennzeichnet, dass** jeder Treiber (20) durch eine Steuerung angesteuert werden kann.

8. Asymmetrische bipolare Spannungsversorgung nach einem der Ansprüche 4 bis 7, **dadurch gekennzeichnet, dass** die sekundären Halbleiterschalter (14-17) die sekundärseitige Vollbrückenschaltung (3) bilden, die über eine weitere Gleichspannungsquelle (5) mit Gleichspannung versorgt werden kann.

9. Asymmetrische bipolare Spannungsversorgung nach einem der Ansprüche 1 bis 3 oder System nach einem der Ansprüche 4 bis 8, **dadurch gekennzeichnet, dass** der Transformator (1) als Planartransformator aufgebaut ist, wobei ein oberer und ein unterer Layer mit je einer Primärwicklung (7a, 7b) vorgesehen sind, zwischen denen die Layer mit den Sekundärwicklungen (8) angeordnet sind.

**Claims**

1. An asymmetrical bipolar voltage supply with a transformer (1), two DC voltage sources with different voltages (U1, U2) and a primary-side voltage supply (2), wherein the transformer (1) has a primary winding (7) and multiple secondary windings (8), **characterized in that** the primary-side voltage supply has a full-bridge circuit (2) with four primary semiconductor switches (10-13), wherein each leg of the full-bridge circuit (2) is connected to another of the two DC voltage sources and to another end of the primary winding (7), wherein two oppositely polarized winding voltage half waves Uw1 and Uw2 can be generated with different amplitudes in the transformer (1) in a period, so that oppositely polarized voltages with different amplitudes can be tapped at each secondary winding, and each secondary winding (8) is connected to a corresponding rectifier circuit (9), wherein each rectifier circuit (9) is designed to generate two asymmetrical bipolar voltages.

2. The asymmetrical bipolar voltage supply according to claim 1, **characterized in that** at least one DC voltage source to be connected to the primary-side voltage supply (2) is controlled.

3. The asymmetrical bipolar voltage supply according to one of claims 1 to 2, **characterized in that** the primary semiconductor switches (10-13) are designed to be switched, so that the winding voltage $U_{W1}$ is applied to the at least one primary winding (7) for a time period $t_1$ and the inverted winding voltage $U_{W2}$ is applied for a time period $t_2$, wherein the integral below the winding voltage $U_{W1}$ over time period $t_1$ corresponds to the integral below the winding voltage $U_{W2}$ over the time period $t_2$.

4. A system comprising a secondary-side full-bridge circuit (3) and the asymmetrical bipolar voltage supply according to one of claims 1 to 3, **characterized in that** multiple secondary semiconductor switches (14-17) are provided on the secondary side, wherein precisely one secondary winding (8) is assigned to each secondary semiconductor switch (14-17).

5. The system according to claim 4, **characterized in that** each secondary semiconductor switch (14-17) is assigned a driver (20) for activating that semiconductor switch (14-17).

6. The system according to claim 5, **characterized in that** the two voltage inputs of each driver (20) are connected to the output of a rectifier circuit (9) with diodes and capacitors assigned to the driver (20) .

7. The system according to one of claims 5 to 6, **characterized in that** each driver (20) can be activated by a control.

8. An asymmetrical bipolar voltage supply according to one of claims 4 to 7, **characterized in that** the secondary semiconductor switches (14-17) form the secondary-side full-bridge circuit (3), which can be supplied with DC voltage via a further DC voltage source (5).

9. The asymmetrical bipolar voltage supply according to one of claims 1 to 3 or the system according to one of claims 4 to 8, **characterized in that** the transformer (1) is constructed as a planar transformer, wherein an upper and a lower layer are each provided with a primary winding (7a, 7b) between which the layers with the secondary windings (8) are arranged.

**Revendications**

1. Alimentation en tension bipolaire asymétrique avec un transformateur (1), deux sources de tension continue avec deux tensions différentes (U1, U2) et une alimentation en tension côté primaire (2), dans laquelle le transformateur (1) présente un enroulement primaire (7) et plusieurs enroulements secondaires (8), **caractérisée en ce que** l'alimentation en tension côté primaire présente un circuit en pont complet (2) avec quatre commutateurs à semi-conducteur primaires (10-13), dans laquelle chaque branche du circuit en pont complet (2) est reliée à une autre des deux sources de tension continue et à une autre extrémité de l'enroulement primaire (7), avec laquelle dans le transformateur (1) peuvent être produites, dans une période, deux demi-ondes de tension de spire Uw1 et Uw2 polarisées de façon opposée avec des amplitudes différentes de sorte qu'à chaque enroulement secondaire peuvent être prélevées des tensions polarisées de façon opposée avec une amplitude différente, et de sorte que chaque enroulement secondaire (8) est relié à un circuit redresseur correspondant (9), chaque circuit redresseur (9) étant conçu pour produire deux tensions bipolaires asymétriques.

2. Alimentation en tension bipolaire asymétrique selon la revendication 1, **caractérisée en ce qu'**au moins une source de tension continue à relier à l'alimentation en tension côté primaire (2) est réglée.

3. Tension d'alimentation bipolaire asymétrique selon l'une des revendications 1 à 2, **caractérisée en ce que** les commutateurs à semi-conducteur primaires (10-13) sont conçus pour être commutés de manière à ce que sur le au moins un enroulement primaire (7) est appliquée, pendant un laps de temps $t_1$, la tension de spire $U_{W1}$ et, pendant un laps de temps $t_2$, la tension de spire invertie $U_{W2}$, l'intégrale sous la tension de spire $U_{W1}$ pendant le laps de temps $t_1$ correspondant à l'intégrale sous la tension de spire $U_{W2}$ pendant le laps de temps $t_2$.

4. Système comprenant un circuit en pont complet côté secondaire (3) et l'alimentation en tension bipolaire asymétrique selon l'une des revendications 1 à 3, **caractérisé en ce que** du côté secondaire sont prévus plusieurs commutateurs à semi-conducteur secondaires (14-17), dans lequel à chaque commutateur à semi-conducteur secondaire (14-17) est affecté exactement un enroulement secondaire (8).

5. Système selon la revendication 4, **caractérisé en ce qu'**à chaque commutateur à semi-conducteur secondaire (14-17) est affecté un pilote (20) pour commander ledit commutateur à semi-conducteur (14-17).

6. Système selon la revendication 5, **caractérisé en ce que** les deux entrées de tension de chaque pilote (20) sont reliées à la sortie d'un circuit à redresseur (9) affecté au pilote (20) avec des diodes et des condensateurs.

7. Système selon l'une des revendications 5 à 6, **caractérisé en ce que** chaque pilote (20) peut être commandé par une commande.

8. Alimentation en tension bipolaire asymétrique selon l'une des revendications 4 à 7, **caractérisée en ce que** les commutateurs à semi-conducteur secondaires (14-17) forment le circuit en pont complet côté secondaire (3) qui peut être alimenté en tension continue par une autre source de tension continue (5).

9. Alimentation en tension bipolaire asymétrique selon l'une des revendications 1 à 3 ou système selon l'une des revendications 4 à 8, **caractérisée en ce que** le transformateur (1) est monté comme un transformateur planaire, dans laquelle une couche supérieure et une couche inférieure avec chacune un enroulement primaire (7a, 7b) sont prévues, entre lesquelles sont disposées les couches avec les enroulements secondaires (8).

# Fig. 1

EP 3 332 481 B1

Fig. 2

Fig. 3

EP 3 332 481 B1

Fig. 5

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20150137871 A1
- US 20120092895 A1
- US 3938025 A